# Europäisches Patentamt
# European Patent Office
# Office européen des brevets

(19)

(11) Veröffentlichungsnummer: **0 103 707**
**B1**

(12)

# EUROPÄISCHE PATENTSCHRIFT

(45) Veröffentlichungstag der Patentschrift:
29.06.88

(21) Anmeldenummer: 83107381.2

(22) Anmeldetag: 27.07.83

(51) Int. Cl.⁴: **H 03 J 1/04,** H 04 N 5/44,
H 03 J 9/00

(54) Benutzerführende Bedienung bei Geräten der Unterhaltungselektronik.

(30) Priorität: 29.07.82 DE 3228354

(43) Veröffentlichungstag der Anmeldung:
28.03.84 Patentblatt 84/13

(45) Bekanntmachung des Hinweises auf die Patenterteilung:
29.06.88 Patentblatt 88/26

(84) Benannte Vertragsstaaten:
DE FR GB IT NL

(56) Entgegenhaltungen:
EP-A-0 068 422

IEEE TRANSACTIONS ON CONSUMER
ELECTRONICS, Band CE-24, Nr. 3, August 1978,
Seiten 436-441, IEEE, New York, US; C. CLIFFORD
u.a.: "Microprocessor based, software defined
television controller"

(73) Patentinhaber: ALCATEL N.V., Strawinskylaan 537
(World Trade Center), NL- 1077 XX Amsterdam
(NL)
(84) Benannte Vertragsstaaten: FR GB IT NL

(73) Patentinhaber: Standard Elektrik Lorenz
Aktiengesellschaft, Hellmuth- Hirth- Strasse 42,
D-7000 Stuttgart 40 (DE)
(84) Benannte Vertragsstaaten: DE

(72) Erfinder: Schepers, Charles, Hirschäckerstrasse
44a, D-7500 Karlsruhe- Hagsfeld (DE)
Erfinder: Schröder, Wolfgang, Allensteiner Strasse
13, D-7530 Pforzheim (DE)

(74) Vertreter: Pohl, Heribert, Dipl.- Ing, Standard
Elektrik Lorenz AG Patent- und Lizenzwesen
Postfach 30 09 29, D-7000 Stuttgart 30 (DE)

EP 0 103 707 B1

Anmerkung: Innerhalb von neun Monaten nach der Bekanntmachung des Hinweises auf die Erteilung des europäischen Patents im
Europäischen Patentblatt kann jedermann beim Europäischen Patentamt gegen das erteilte europäische Patent Einspruch einlegen.
Der Einspruch ist schriftlich einzureichen und zu begründen. Er gilt erst als eingelegt, wenn die Einspruchsgebühr entrichtet worden
ist (Art. 99(1) Europäisches Patentübereinkommen).

LIBER, STOCKHOLM 1988

## Beschreibung

Die Erfindung betrifft ein Verfahren zum Steuern eines Geräts der Unterhaltungselektronik sowie ein Gerät der Unterhaltungselektronik mit verschiedenen Betriebszuständen und einem Bedienteil, mit dem die Verschiedenen Betriebszustände ausgewählt bzw. eingestellt werden, mit einem Anzeigenfeld und/oder einem Bildschirm, sowie mit einem Zeichengenerator, der auf dem Anzeigenfeld und/oder dem Bildschirm Einblendungen erzeugt, die den jeweiligen Betriebszustand (z. B. den eingestellten Kanal) oder eine andere wechselnde Größe (z. B. die Uhrzeit) anzeigen.

Die stetige Weiterentwicklung der Technik hat auch bei Geräten der Unterhaltungselektronik nicht nur zur Folge, daß diese technisch immer besser werden, sondern daß sie auch für den Benutzer immer mehr Möglichkeiten bieten. Ein zweiter übertragener Tonkanal beim Fernsehen bietet z. B. die Möglichkeit, entweder einen Stereoton oder zwei getrennte Tonkanäle zu übertragen, wobei dann vorzugsweise zwischen Begleittexten zweier verschiedener Sprachen gewählt werden kann. Auch Erweiterungen für Videotext, Bildschirmtext oder Fernsehspiele sind bekannt. Dies bedingt, daß immer mehr zusätzliche Einstellungen durchgeführt werden müssen oder können. Gleichzeitig geht die Forderung des Benutzers immer starker in Richtung auf eine Bedienungsvereinfachung hin. Insbesondere wird großer Wert auf eine Fernbedienungsmöglichkeit gelegt. Auch der Hersteller legt Wert auf eine möglichst einfache Bedienung, um möglichst noch zusätzliche Kundenkreise anzusprechen. Ein Fernbedienteil muß so ausgelegt sein, daß es bequem in einer Hand zu halten und mit der anderen Hand oder gar mit der haltenden Hand selbst zu bedienen ist. Für die Fernbedienung eines Geräts oder einer Gerätekombination mit vielen Einstellmöglichkeiten bestehen verschiedene Möglichkeiten:

- Man beschränkt sich darauf, nur die wichtigsten Funktionnen (z. B. Ein-Aus, Lautstärke, Helligkeit, Senderauswahl) fernbedienbar zu machen und den Rest (z. B. Farbsättigung, Höhen und Tiefen, Balance) nur am Gerät selbst einstellen zu können.

- Man bedient alle Komponenten einer Anlage (z. B. Fernsehempfänger, Videorecorder, evtl. getrenntes Hifi-Stereotonteil) mit separaten Fernbedienteilen.

- Man verwendet tatsächlich Fernbedienteile, die für jede Funktion ein Stellglied, vorzugsweise eine Taste, aufweisen. Die Tasten und deren Abstände untereinander werden dabei zwangsläufig recht klein. Eine gruppenweise Zusammenfassung von Tasten bedingt zusätzliche Zwischenräume zwischen den einzelnen Gruppen. Die Beschriftung müßte recht klein ausfallen und wäre damit praktisch unlesbar, besonders im Hinblick darauf, daß derartige Geräte häufig im Halbdunkel verwendet werden.

- Man verwendet ein Bedienteil, auf dem nur eine überschaubare Anzahl von Tasten angeordnet ist. Mit einem Teil der Tasten können dann jeweils verschiedene Funktionen ausgelöst werden, wobei die Auswahl unter den verschiedenen, einer Taste zugeordneten Funktionen durch das vorangehende Betätigen weiterer Tasten getätigt wird. Diese Tasten müssen dann entweder mehrfach beschriftet werden, wodurch die Beschriftung dann wieder klein und unlesbar wird oder es wird nur die jeweilige Grundfunktion gekennzeichnet, die jeweiligen Zusatzfunktionen müssen vom Benutzer entweder nachgeschlagen oder auswendig gelernt werden.

-Eine vom Benutzer getätigte Einstellung wird durch Einblendung auf dem Bildschirm eines Fernsehgerätes oder auf einem sonstigen Anzeigenfeld quittiert, um so auf Fehleinstellungen aufmerksam zu machen.

In all diesen Fällen ist jedoch ein Benutzer, besonders ein mit dem Gerät oder der Gerätekonfiguration nicht vertrauter Benutzer, nicht oder kaum in der Lage, alle von ihm gewünschten Einstellungen ohne besondere Anstrengung durchführen zu können. Im günstigsten Fall wird er auf eine Fehlbedienung sofort aufmerksam gemacht.

Auch im Audiobereich haben die Geräte oder Gerätekombinationen (z. B. Verstärker, Empfänger, Kassettengerät, Plattenspieler) eine Bedienungsvielfalt erreicht, daß oft die Größe des gesamten Geräts durch die Bedienungselemente bestimmt wird. Auch bei solchen Geräten sollte eine Fernbedienung möglich sein.

Aus der Druckschrift IEEE Transactions und Consumer Electronics, Band CE - 24, Nr. 3, August 1978, Seiten 436 - 441 ist ein Fernsehgerät bekannt, das mit einem mikroprozessorgesteuerten Bedienteil versehen ist. An dem Bedientei 1 werden die verschiedenen Betriebszustände des Geräts eingestellt und auf dem Bildschirm Texte eingeblendet, die die Zeitprogrammierung des Geräts im Dialog mit dem Teilnehmer ermöglichen. Das Bedienteil weist eine Taste auf, mit der die Zeitprogrammierung eingeleitet wird, sowie Tasten für die einzelnen Wochentage, Zifferntasten zur Eingabe des Tages und des Monats und eine Bestätigungstaste. In einem anderen Ausführungsbeispiel weist das Bedienteil eine Starttaste für die Zeitprogrammierung, eine NEIN-, eine JA-Taste und Zifferntasten für die Eingabe der Uhrzeit und des Kanals auf. Auf dem Bildschirm werden jeweils zwei Zeilen angezeigt: die erste Zeile zeigt dem Benutzer die Daten an, die einzugeben sind oder fordert ihn zur Bestätigung auf, die zweite Zeile zeigt ihm die Daten an, die er eingegeben hat.

Mit dem bekannten Bedienteil ist es nur möglich, den Einschalt- und den Ausschaltzeitpunkt für das Fernsehgerät einzugeben. Weitere Funktionen oder gar weitere an das Fernsehgerät angeschlossene Geräte der Unterhaltungselektronik können damit nicht gesteuert werden.

In der EP-A-0 068 422 (Veröffentlichungsdatum: 05.01.83) ist ein Fernsehgerät beschrieben, mit dem neben dem normalen Videobild auch formatfüllend alphanumerische Zeichen dargestellt werden können. Damit kann es zum Beispiel auch als Monitor für eine Datenverarbeitungsanlage verwendet werden. Sein Fernbedienungsgeber weist allerdings 64 Tasten auf, von denen 32 durch eine Gruppenauswahltaste von einer ersten in eine zweite Funktion umgeschaltet werden können. Mit dem Bedienteil kann die Ein- und Ausschaltzeit des Fernsehgerätes eingegeben und außerdem können andere Funktionen des Gerätes gesteuert werden.

Die Vielzahl der Tasten und die Kompliziertheit des Bedienungsvorgangs läßt es sehr unwahrscheinlich erscheinen, daß ein nur an Fernseh- und Videoprogrammen interessierter Benutzer, der nicht Computerfachmann ist, in der Lage sein wird, das Gerät tatsächlich zu bedienen.

Der Erfindung liegt die Aufgabe zugrunde, die Bedienung von Geräten oder Gerätekombinationen der Unterhaltungselektronik soweit zu vereinfachen, daß auch ein ungeübter Benutzer mit möglichst wenig Aufwand sämtliche erforderlichen oder gewünschten Einstellungen tätigen kann. Auch bei einer größeren Anlage sollen sämtliche Funktionen von einem einzigen Bedienteil aus betätigt werden können. Das Bedienteil soll nur eine überschaubare Anzahl von Betätigungselementen aufweisen; eine Mehrfachbeschriftung einzelner Bedienungselemente soll unterbleiben.

Die Aufgabe wird erfindungsgemäß gelöst durch das in Ausspruch 1 angegebene Verfahren. Vorteilhafte Weiterführungen der Erfindung sind aus den Unteransprüchen zu entnehmen. Das zugehörige Gerät ist in Anspruch 13 angegeben.

Im folgenden wird die Erfindung anhand eines Ausführungsbeispiels unter Zuhilfenahme der beiliegenden Zeichnung weiter erläutert.

Fig. 1    zeigt als Ausführungsbeispiel eine erfindungsgemäße Anordnung bestehend aus einem Gerät der Unterhaltungselektronik mit einem Fernbedienteil und zwei angeschlossenen weiteren Geräten der Unterhaltungselektronik, die erfindungsgemäß über das Fernbedienteil des ersten Geräts mitbedient werden.

Fig. 2    zeigt als Ausführungsbeispiel das Blockschaltbild eines erfindungsgemäßen Fernsehempfangsgeräts.

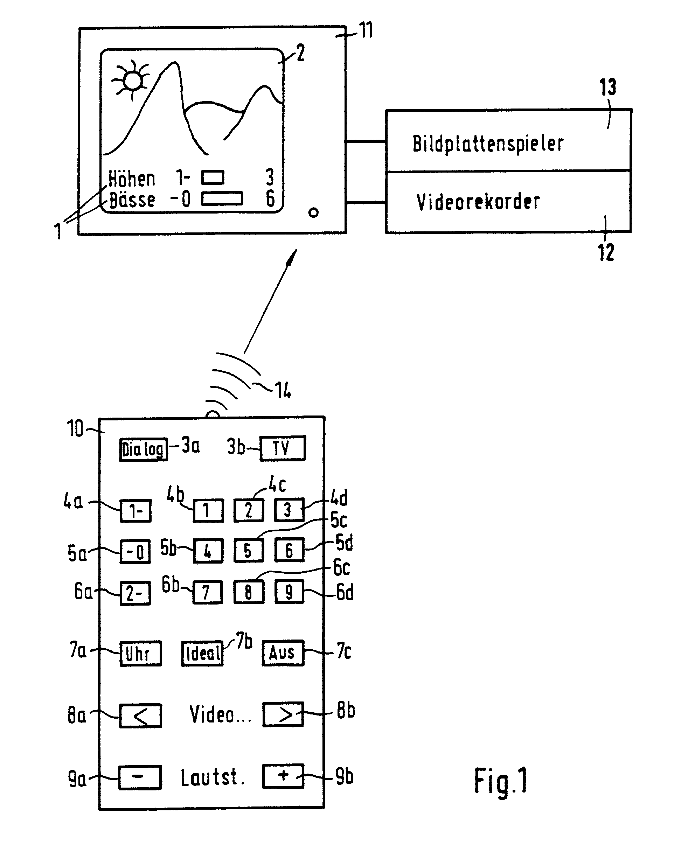

Fig 1 zeigt ein Fernsehempfangsgerät 11 mit einem Bildschirm 2 und einem davon getrennten Fernbedienteil 10. Die Verbindung 14 zwischen Fernbedienteil 10 und Fernsehempfangsgerät 11 ist durch skizzierte Wellen angedeutet. Ob diese Verbindung 14 wie angedeutet durch Wellen (z. B. Ultraschall, Infrarot) oder auf andere Weise erfolgt, ist für die Erfindung unerheblich. Auch bei einem in das Fernsehempfangsgerät 11 fest oder lösbar eingebauten Bedienteil kann die Bedienung durch die Erfindung vereinfacht werden.

Auf dem Bildschirm 2 des Fernsehempfangsgeräts 11 sind Einblendungen 1 in die laufende Darstellung sichtbar. Die Einblendungen 1 bestehen teils aus Schriftzeichen, teils aus einfachen Graphiken (hier Balkendiagramme). Unterschiedliche Farben dienen der Gliederung und der Hervorhebung. Auf besonders wichtige Teile wird durch Blinken aufmerksam gemacht.

An das Fernsehempfangsgerät 11 sind hier noch zwei weitere Geräte, ein Videorecorder 12 und ein Bildplattenspieler 13 angeschlossen. Die Anschlüsse umfassen u.a. auch Steuerleitungen, über die die angeschlossenen Geräte vom Fernsehempfangsgerät, und damit von dessen Fernbedienteil aus fernbedient werden können. Auch können die angeschlossenen Geräte 12, 13 Informationen über ihren augenblicklichen Zustand (z. B. Bandende, Schneller Vorlauf) an das Fernsehempfangsgerät melden, um dort durch Einblendungen 1 angezeigt zu werden.

Das Fernbedienteil 10 weist eine Anzahl von Tasten 3 bis 9 auf, mit denen das Fernsehempfangsgerät 11 und die angeschlossenen Geräte 12, 13 bedient werden können. Mit den Tasten 4 bis 6 kann der Empfang eines von bis zu 29 Fernsehprogrammen eingestellt werden. Durch aufeinanderfolgendes Drücken etwa der Tasten 4a und 5b wird das Fernsehprogramm "14" eingestellt. Es ist bereits üblich, eine gerade erfolgte Einstellung durch Einblendung in das Fernsehbild oder auf einem davon getrennten Display zumindest für einige Sekunden darzustellen. Im vorliegenden Fall würde dann z. B. in der rechten oberen Ecke die Zahl 14 oder ausführlicher, im unteren Teil des Fernsehbilds der Text "Programm 14 Kanal 34" eingeblendet werden. Gleichzeitig wird das Fernsehempfangsgerät 11, sofern erforderlich, eingeschaltet. Beim Drücken der Tasten 9a und 9b verändert sich die Lautstärke. Weitere Einstellungen sind für einen Fernsehzuschauer in der Regel zunächst nicht erforderlich.

Das Betätigen der Taste 7a löst eine kurzzeitige Einblendung der Uhrzeit in das Fernsehbild aus. Das Drücken der Taste 7c schaltet die gesamte Anlage aus. Sie geht in einen Standby-Betrieb über und kann nur durch Auswahl eines Programms wieder aktiviert werden. Weitere Einstellungen am aktivierten Gerät sind durch Drücken der Auswahltaste 3a möglich.

Durch Drücken der Auswahltaste 3a wird zunächst die erste Seite eines im Fernsehempfangsgerät 11 eingebauten Textspeichers aufgerufen und dessen Textinhalt auf dem Bildschirm zur Einblendung gebracht. Dabei erscheinen z. B. untereinander die Worte "Kontrast", "Farbstärke" und "Helligkeit". Hinter "Kontrast" ist dann die Kennzeichnung derjenigen Tasten eingeblendet, mit denen der Kontrast vermindert bzw. erhöht werden kann. Im Beispiel sind es etwa die Kennzeichnungen der Tasten 4a und 4d, was bedeutet, daß die Betätigung der Taste 4a bzw. 4d eine Verringerung oder Erhöhung des Kontrasts zur Folge hat. Zwischen die beiden Einblendungen für die Kennzeichnungen der Tasten 4a und 4d wird in Form eines Balkens der jeweils gerade eingestellte Wert des Kontrasts dargestellt. Entsprechend wird durch Betätigung der Tasten 5a und 5d die Farbstärke sowie durch Betätigen der Tasten 6a und 6d die Helligkeit eingestellt. So vorgenommene Einstellungen können jederzeit durch Betätigung der Taste 7b rückgängig gemacht werden.

Durch Betätigen der Taste 7b werden alle Analogeinstellungen, die vom Fernbedienteil 10 aus vorgenommen wurden, unwirksam gemacht. Damit werden dann diejenigen Einstellungen wirksam, die durch Potentiometer, Trimmer oder auf andere Weise fest vorgenommen wurden und die dem Idealzustand entsprechen sollten.

Die Tasten 4b, 4c, 5b, 5c, 6b, 6c werden für Analogeinstellungen nicht herangezogen. Sie können für Umschaltvorgänge verwendet werden. Auf solche Umschaltvorgänge kann, ebenfalls durch vorher festgelegte Texteinblendungen, hingewiesen werden. So kann etwa die Texteinblendung "Videotext = 1 Videorecorder = 4" bedeuten, daß beim Betätigen der mit "1" gekennzeichneten Taste 4b in den Videotextbetrieb umgeschaltet wird und beim Betätigen der mit "4" gekennzeichneten Taste 5b der Videorecorder in Betrieb genommen wird.

Sowohl beim Übergang auf eine andere Betriebsart oder ein anderes Gerät wie auch beim erneuten Betätigen der Auswahltaste 3a gilt der durch die Einblendungen unterstützte und auch nur während der Zeit der Einblendungen überhaupt mögliche Einstellvorgang als beendet. Es wird eine neue Seite des Textspeichers zur Anzeige gebracht und gleichzeitig die Tasten 4 bis 6 auf andere Funktionen umgeschaltet.

Durch Drücken der Auswahltaste 3a wird die nächste Textseite zur Anzeige gebracht. Waren auf der ersten Textseite beispielsweise alle Funktionen aufgeführt, die das Bild des Fernsehempfangsgeräts beeinflussen, so werden auf der zweiten Textseite etwa solche Funktionen zusammengefaßt, die den Ton des Fernsehempfangsgeräts 11 beeinflussen. Dies können Höhen, Bässe, Balance und Umschaltmöglichkeit auf Tonkanal 1, Tonkanal 2 oder Stereo sein. Gleichzeitig mit dem Einblenden der zweiten Textseite werden die Tasten 4 bis 6 in ihrer Funktion umgeschaltet. Die übrigen Tasten, u.a. auch die Tasten 9a, b für die Lautstärke, behalten ihre Funktion stets bei.

Auf jeder Textseite sind Hinweise auf eine Gruppe zusammengehöriger Einstellfunktionen und die hierzu jeweils zu betätigenden Tasten zusammengefaßt. Mehrere sachlich zusammengehörige Gruppen von Einstellfunktionen werden zu Paketen von aufeinanderfolgenden Textseiten zusammengefaßt. Ein derartiges Paket besteht z. B. aus all den Textseiten, mit deren Hilfe ein angeschlossener Videorecorder zur Aufnahme programmiert wird. Ein weiteres Paket kann z. B. die Wiedergabe vom Videorecorder betreffen.

Der Übergang von einer Textseite zur anderen kann auf verschiedene Weise erfolgen:

- Durch Betätigung der Auswahltaste 3a wird jeweils auf die nächste Textseite umgeschaltet.

- Nach Ablauf einer bestimmten Zeit, gemessen von der letzten Tastenbetätigung an, wird automatisch auf die nächste Textseite umgeschaltet.

- Bei jeder Textseite wird eine Auswahl weiterer Textseiten angegeben, die durch Betätigen einer bestimmten, angegebenen Taste ausgewählt werden kann. Diese Seite wird in der Regel auch die erste Seite eines ganzen Pakets sein.

- Eine bestimmte Seite kann auch durch Drücken der Auswahltaste 3a und anschließendes Eingeben einer Seitenzahl über die Tasten 4 bis 6 direkt ausgewählt werden, wenn die Seitennummer bekannt ist.

- Durch Drücken einer Abschlußtaste 3b wird, je nach Ausführung, entweder in den Grundzustand oder auf die erste Seite eines folgenden Pakets umgeschaltet.

- Nach Betätigung der Abschlußtaste 3b kann durch Eingabe einer Nummer über die Tasten 4 bis 6 gezielt entweder wieder in den Grundzustand zurückgeschaltet oder an den Anfang eines ausgewählten Pakets geschaltet werden.

- Von der letzten Seite eines vollständigen Pakets wird zunächst wieder in den Grundzustand zurückgeschaltet. Die erste Textseite des nächsten Pakets kann nur durch Betätigen entweder der Auswahltaste 3a oder der Abschlußtaste 3b, nicht aber durch Zeitablauf ausgelöst werden.

Die einzelne Textseite ist so aufgebaut, daß sie dem Benutzer möglichst viel Hilfe zur Bedienung gibt. Dazu gehört nicht nur, daß sachlich zusammengehörige Funktionen auch auf einer Textseite oder auf unmittelbar aufeinanderfolgenden Textseiten aufgeführt sind. Es gehört auch dazu, daß zur Kontrolle der erfolgten Einstellungen ein möglichst großer Teil des Bildes sichtbar und ohne Einblendungen bleibt. Es ist sinnvoll, die Textseite graphisch so aufzubauen, etwa in Form einer Tabelle, die die Anordnung der Tasten auf dem Bedienteil wiedergibt, daß der Benutzer nicht nur leicht erkennen kann, welche Taste er drücken muß, um eine bestimmte Funktion auszulösen, sondern daß er diese Taste auch möglichst schnell auf seinen Fernbedienteil findet. Auch die Verwendung unterschiedlicher Farben erleichtert die Übersicht.

Eine Textseite gibt nur an, wie eine bestimmte Einstellung zu erfolgen hat. Gleichzeitig mit der. Einblendung von Textseiten können, in bekannter Weise, Einblendungen erfolgen, die das Ergebnis einer Einstellung wiedergeben. Dies sind zum einen z. B. Frequenz oder Kanalangaben, die durch Zahleneinblendungen wiedergebbar sind, zum andern sind dies analoge Größen, wie z. B. die Verstärkung der Höhen und der Bässe, die durch graphische Darstellung, insbesondere Balkendarstellungen, darstellbar sind, die gleichzeitig mit der Textseite eingeblendet werden.

Insbesondere solche Schaltfunktionen, mit denen in andere Betriebsarten (etwa auf Videotextbetrieb) oder auf andere Gerätekombinationen (etwa auf Schallplattenwiedergabe) umgeschaltet wird, sollten zwar nicht von allen Textseiten aus, jedoch auch nicht nur von einer Textseite ausschaltbar sein. Der Hinweis auf derartige Schaltfunktionen und damit zusammenhängend auch die Umschaltung der entsprechenden Tasten erfolgt von mehreren Textseiten aus.

Diejenigen Funktionen, die schon beim gewöhnlichen Fernsehempfang benötigt werden, etwa die Einstellung des empfangenen Programms, dürfen nicht erst nach Auswahl einer bestimmten Textseite einstellbar sein. Diese Funktionen müssen schon im Grundzustand einstellbar sein, also bevor die zugehörigen Tasten durch Auswahl einer Textseite auf eine andere Funktion umgeschaltet werden. Besonders wichtige Funktionen müssen jederzeit einstellbar sein, gleichgültig, ob gerade eine bestimmte Textseite ausgewählt ist oder nicht. Solche Funktionen müssen auf Tasten untergebracht werden, die nicht auf andere Funktionen umschaltbar sind. Dies gilt vor allem für die Lautstärke (Tasten 9a, b) wie auch für die Umschaltung auf Standby-Betrieb (Taste 7c). Auch der Vor- und Rücklauf angeschlossener Bandgeräte wird über solche Tasten (8a, b) bedient, deren Funktion sich bei der Auswahl von Textseiten nicht ändert.

Nicht alle Funktionen dürfen von jedem Benutzer durchführbar sein. z. B. darf ein Videoband, das in einen angeschlossenen Videorecorder eingelegt ist, nicht von jedermann gelöscht werden. Ein Band kann nur gelöscht werden, wenn zuvor über die sonst zur Kanalwahl vorgesehenen Zifferntasten 4 bis 6 ein hierfür vorgesehener Sperrcode eingetippt wird. Selbstverständlich wird hier zwar durch Schrifteinblendung darauf hingewiesen, daß ein Sperrcode einzugeben ist, nicht aber, welcher. Für verschiedene zu sichernde Bedienungsfunktionen wird entweder derselbe Sperrcode verwendet oder jeweils ein anderer. Ein vom Benutzer eingegebener Sperrcode wird vor Auslösen der jeweiligen Funktion anhand eines im Gerät abgespeicherten Codes überprüft. Dieser Code ist entweder schon vom Hersteller oder vom Benutzer selbst vorgegeben. Für vom Benutzer vorzugebende Sperrcodes sind im Gerät elektrisch programmier- und löschbare nichtflüchtige Speicher vorgesehen. Bei einem anderen Ausführungsbeispiel wird der Sperrcode zum Löschen eines Bandes vom Benutzer vor dem Beschreiben des Bandes eingegeben und am Bandanfang abgespeichert. Vor jedem Benutzen des Bandes wird dieser Code in einen Schreib-Lese-Speicher im Gerät übernommen. Erwartet das Gerät die Eingabe eines Sperrcodes, so wird, im Gegensatz zu allen übrigen Eingaben, die folgende Eingabe nicht zur Kontrolle in den Bildschirm eingeblendet.

Es sind Geräte bekannt, bei denen die Signalverarbeitung digital erfolgt. Zur Justierung müssen in solchen Geräten in digitaler Form als Zahlenwerte vorgegebene Koeffizienten verändert werden. Erfindungsgemäß werden, nach Eingabe eines Sperrcodes, Hinweise zur Justierung in den Bildschirm eingeblendet. Die Eingabe neuer Koeffizienten und damit die Justierung erfolgt dann über das Fernbedienteil.

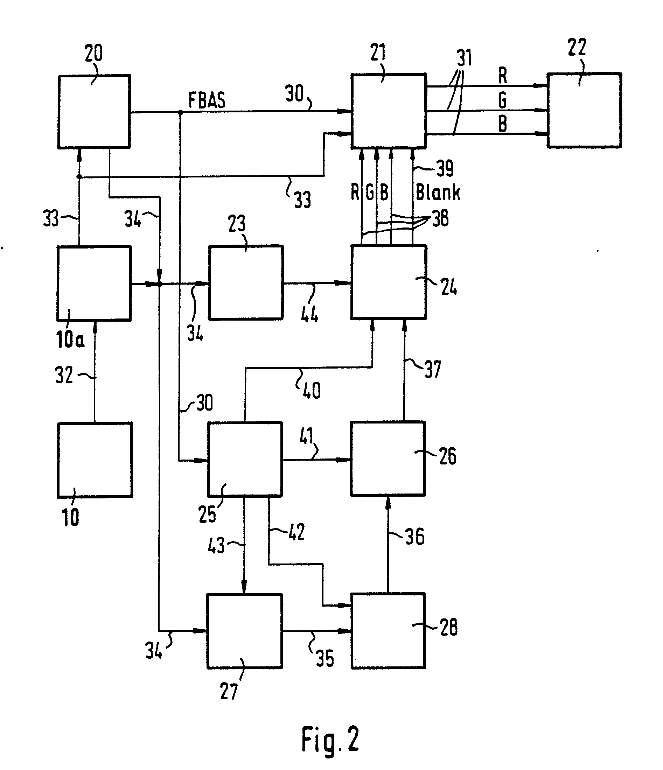

Fig. 2 zeigt den Aufbau und den Signalverlauf im Fernsehempfangsgerät 11 nach Fig. 1. Ein Empfangsteil 20 bildet ein Videosignal (FBAS-Signal) 30. Das Videosignal 30 wird in einem Farbteil 21 in drei Farbsignale 31 aufgespalten, mit denen eine Farbbildröhre 22 angesteuert wird. Die vom Fernbedienteil 10 kommenden Bedienbefehle 32 werden in einem dem Fernbedienteil 10 zugeordneten Decoder 10a in Steuerzeichen 33 umgewandelt. Durch diese Steuerzeichen 33 werden sowohl im Empfangsteil 20, wie auch im Farbteil 21 die erforderlichen Einstellungen veranlaßt. Außerdem werden vom Decoder 10a Anzeigesteuerzeichen 34 erzeugt, mit denen die Einblendungen 1 gesteuert werden.

Die Anzeigesteuerzeichen wählen in einer Seitenauswahlschaltung 27 eine Anzeigenseite aus, deren Adresse über einen Adressbus 35 an einen Anzeigenseitenspeicher 28 gegeben wird. Der Inhalt der ausgewählten Anzeigenseite wird zeichenweise in codierter Form über einen Datenbus 36 an einen Zeichengenerator 26 gegeben. Der Zeichengenerator 26 löst die wiederzugebenden Zeichen in Einzelelemente auf. Im vorliegenden Fall eines Fernsehempfangsgeräts sind diese Einzelelemente Punkte aus einer 7x10-Matrix. Die Einzelelemente werden über einen Zeichenwiedergabebus 37 an eine Wiedergabesteuerschaltung 24 übergeben. In der Wiedergabesteuerschaltung 24 werden Farbsignale (R, G, B) 38 und ein Austastsignal (Blank) 39 gebildet, die im Farbteil 21 ausgewertet werden. Das Austastsignal 39 schaltet um zwischen der Wiedergabe der dem Videosignal 30 entsprechenden Farbe und der Wiedergabe der von den Farbsignalen 38 bestimmten Farbe. Damit wird das normale Fernsehbild aus- und eine Schrift entsprechend der Anzeigenseite eingeblendet.

Eine Taktsteuerschaltung 25 wird vom Videosignal 30 synchronisiert. Sie erzeugt einen Fenstertakt 40, mit dem die Wiedergabesteuerschaltung 24 für eine Einblendung im unteren Bildteil freigegeben wird. Durch einen Wiedergabetakt 41 steuert die Taktsteuerschaltung 25 im Zeichengenerator 26 die richtige Aufeinanderfolge der Einzelelemente. Ein in der Taktsteuerschaltung 25 erzeugter Zeilentakt 42 ruft den Anzeigentext zeilenweise aus dem Anzeigenseitenspeicher 28 ab. Die Seitenauswahlschaltung 27 erhält einen Hilfstakt 43 von der Taktsteuerschaltung 25.

Die Anzeigesteuerzeichen 34 werden auch in einer Steuerzeichenerkennungsschaltung 23 ausgewertet. Die Steuerzeichenerkennungsschaltung 23 gibt Befehle an die Wiedergabesteuerschaltung 24 über einen Wiedergabesteuerbus 44.

Die Steuerzeichenerkennungsschaltung 23 bestimmt die Farbe einzublendender Zeichen und evtl. deren Umrandung, sie läßt bei Bedarf die Anzeige blinken und Veranlaßt die Einblendung zusätzlicher Information. Solche Zusatzinformationen sind insbesondere Informationen über den augenblicklichen Betriebszustand. Es werden die vom Benutzer getätigten Bedienungen bestätigt, der jeweilige Wert vom Benutzer einzustellender oder gerade eingestellter Größen wird über Balkendiagramm dargestellt und Angaben über das empfangene Programm (z. B. Stereosendung) werden angezeigt. Die hierfür erforderlichen Anzeigesteuerzeichen 34 werden in diesem Fall nicht vom Decoder 10a, sondern vom Empfangsteil 20 erzeugt.

In einem weiteren Ausführungsbeispiel ist zwischen Anzeigenseitenspeicher 28 und Zeichengenerator 26 noch ein Schreib-Lese-Speicher zwischengeschaltet. Dadurch können im Anzeigenseitenspeicher 28, der ein Festwertspeicher ist, langsamere und damit auch leistungsgunstigere Speicher verwendet werden.

Bei Geräten, die gleichzeitig zur Videotext- und/oder Bildschirmtextwiedergabe ausgerüstet sind, wird der dann vorhandene Videotext- und/oder Bildschirmtextgenerator für die Ausgabe von Anzeigenseiten mit Bedienungshinweisen mitverwendet. Dieser muß dann im wesentlichen nur noch durch die Seitenauswahlschaltung 27 und den Anzeigenseitenspeicher 28 ergänzt werden.

Die Einblendung vorgegebener Texte als Bedienungshinweis ist nicht auf Fernsehempfangsgeräte oder andere Geräte mit Bildschirm beschränkt. Viele andere Geräte der Unterhaltungselektronik sind mit Anzeigenfeldern ausgestattet, mit deren Hilfe der Benutzer die von ihm getätigten Bedienungsanweisungen überprüfen kann. Hierzu gehören Frequenzanzeigen, auf denen die eingestellte Frequenz abgelesen werden kann. Bei programmierbaren Aufzeichnungsgeräten werden die eingestellten Zeiten angezeigt. Ein solches Anzeigenfeld wird nun erfindungsgemäß nicht nur dazu benutzt, die Bedienung im Nachhinein zu überprüfen, sondern sie durch kurze Hinweise im voraus zu unterstützen. In diesem Fall ist die einzelne Anzeigenseite kürzer und enthält in der Regel nur einen einzigen Bedienhinweis.

Im folgenden werden noch einige weitere Ausführungsmöglichkeiten aufgeführt.

Bei mehreren zusammengeschalteten Geräten der Unterhaltungselektronik werden an allen Anzeigenfeldern dieser Geräte gleichzeitig dieselben Bedienungshinweise ausgegeben. Die Auslösung all dieser Anzeigen erfolgt nur von einem Gerät aus, das dann jeweils als Zentrale wirkt.

Sind mehrere Geräte zusammengeschaltet, die je für sich in der Lage sind, Hinweistexte auszugeben, so wird ein Gerät festgelegt, das als Zentrale wirkt. Diese Voreinstellung ist vom Benutzer abänderbar. Durch Betätigung entsprechender Tasten, worauf durch Einblendung hingewiesen wird, wird ein anderes Gerät zur Zentrale.

**Patentansprüche**

1. Verfahren zum Steuern eines Geräts (11) der Unterhaltungselektronik, bei dem mit einem Bedienteil (10) die verschiedenen Betriebszustände des Geräts (11) eingestellt werden; bei dem Bedienungshinweise in Form von Einblendungen auf einem Bildschirm (2) oder auf einem Anzeigefeld wiedergegeben werden, wobei die Bedienungshinweise über das Bedienteil (10) aus einem Anzeigeseiten, speicher (28) ausgelesen und durch eine Wiedergabesteuerschaltung (24) auf dem Bildschirm (22) oder dem Anzeigefeld dargestellt werden, dadurch gekennzeichnet,
   - daß mindestens ein Teil der Tasten (4a - 6d) des Bedienteils (10) durch eine Auswahltaste (3a) zwischen einer Grunfunktion und mindestens einer Zusatzfunktion umschaltbar ist,
   - daß die Bedienungshinweise zu Gruppen zusammengefaßt sind, wobei die einzelnen Gruppen jeweils einer der Grund- oder Zusatzfunktionen der Tasten (4a - 6d) zugeordnet sind,
   - daß beim Betätigen der Auswahltaste (3a) die der dabei gewählten Grund- oder Zusatzfunktion zugeordneten Bedienungshinweise auf dem Bildschirm (2) oder Anzeigefeld dargestellt werden, und
   - daß die über das Bedienteil (10) ausgeführte Steuerung des Geräts (11) einerseits von der jeweils ausgewählten Grund- oder Zusatzfunktion und der dieser zugeordneten Gruppe von Bedienungshinweisen und andererseits von der jeweils betätigten Taste (4a - 6d) abhängt.

2. Verfahren nach Anspruch 1, dadurch gekennzeichnet, daß über die Tasten (3a - 9b) des Bedienteils (10) auch andere Geräte (12, 13) der Unterhaltungselektronik bedient werden und daß hierzu entsprechende Texte aus dem Anzeingeseiten speicher (28) ausgelesen und auf dem Bildschirm eingeblendet werden.

3. Verfahren nach Anspruch 1, dadurch gekennzeichnet, daß der Übergang von einer Gruppen von Tastenfunktionen auf eine andere Gruppe von Tastenfunktionen selbsttätig nach Ablauf einer vorgegebenen Zeit durchgeführt wird.

4. Verfahren nach Anspruch 1, dadurch gekennzeichnet, daß eine bestimmte Gruppe von Tastenfunktionen ausgewählt wird, wenn zuerst die Auswahltaste (3a) und anschließend eine weitere Taste (4a - 6b) oder eine Kombination von weiteren Tasten gedrückt wird.

5. Verfahren nach Anspruch 1, dadurch gekennzeichnet, daß mehrere sachlich zusammengehörige Gruppen von Tastenfunktion zu einem Paket zusammengefaßt sind, und daß die einzelnen Gruppen des Pakets selbständig oder durch Drücken der Auswahltaste (3a) aufeinanderfolgen.

6. Verfahren nach Anspruch 5, dadurch gekennzeichnet, daß nach Durchlauf eines vollständigen Pakets wieder auf die Grundfunktionen der Tasten (4a - 6d) zurückgeschaltet wird.

7. Verfahren nach Anspruch 1, dadurch gekennzeichnet, daß durch Betätigen einer Abschlußtaste (3b) wieder auf die Grundfunktion zurückgeschaltet wird.

8. Verfahren nach Anspruch 1, dadurch gekennzeichnet, daß durch Betätigen einer Abschlußtaste (3b) auf die erste Gruppe einer von mehreren zu einem Paket zusammengefaßten Gruppen von Tastenfunktionen umgeschaltet wird.

9. Verfahren nach Anspruch 1, dadurch gekennzeichnet, daß als Grundfunktionen solche Funktionen festgelegt sind, die für die wichtigsten Einstellungen des Geräts erforderlich sind, und daß besonders wichtige Funktionen Tasten (7b, 7c, 9a, 9b) ohne Zusatzfunktionen zugeordnet sind.

10. Verfahren nach Anspruch 1, dadurch gekennzeichnet, daß die jeweils gültige Tastenfunktion, zumindest der Tasten mit Zusatzfunktion (4a - 6d), in Form einer Tabelle eingeblendet wird, die die Anordnung der Tasten auf dem Bedienteil (10) wiedergibt.

11. Verfahren nach Anspruch 1, dadurch gekennzeichnet, daß Verschiedene Bedienungsfunktionen erst nach Eingabe eines oder mehrerer nicht angezeiter Sperrcodesauslösbar sind.

12. Verfahren nach Anspruch 1, bei dem eine Justierung ganz oder teilweise durch Verändern von abgespeicherten Digitaldaten erfolgt, dadurch gekennzeichnet, daß diese Justierung über das Bedienteil (10) des Geräts (11) erfolgt und daß dabei die Justierung unterstützende Bedienungshinweise auf dem Bildschirm (2) eingeblendet werden.

13. Gerät der Unterhaltungselektronik, das folgende Bestandteile aufweist:
- einen Bildschirm (22) oder ein Anzeigefeld, auf dem außer dem normalen Programminhalt oder der normalen Anzeige Bedienungshinweise für den Benutzer wiedergegeben werden,
- eine Wiedergabesteuerschaltung (24), durch die diese Bedienungswünsche ausgegeben und gleichzeitig an ihrer Stelle der normale Programminhalt oder die normale Anzeige unterdrückt wird,
- ein Bedienteil (10), mit dem von dem Benutzer Bedienungswünsche eingegeben werden,
- eine Steuerzeichenerkennungsschaltung (23), durch die Steuerzeichen ausgewertet werden, die von dem Bedienteil (10) ausgesendet werden und durch die die Wiedergabesteuerschaltung (24) gesteuert wird,
- ein Anzeigeseitens (28), aus dem die Bedienungshinweise abgerufen und mittels eines Zeichengenerators (26) auf dem Bildschirm (2) oder dem Anzeigefeld dargestellt werden, dadurch gekennzeichnet,
daß die Bedienungshinweise in dem Anzeigeseitenspeicher (28) gruppenweise zusammengefaßt sind,
- daß das Bedienteil (10) mit einer Auswahltaste (3a) versehen ist durch die mindestens ein Teil seiner Tasten (4a - 6d) von einer Grundfunktion in eine Zusatzfunktion umschaltbar ist,
- daß durch eine Seitenauswahlschaltung (27) diejenige Gruppe von Bedienungshinweisen, die der jeweils gewählten Funktion der Tasten entspricht, aus dem Anzeigeseitepeicher (28) ausgelesen und dargestellt wird, und
- daß die über das Bedienteil (10) ausgeführte Steuerung des Geräts sowohl von der jeweils auf dem Bildschirm (2) oder dem Anzeigefeld dargestellten Gruppe von Bedienungshinweisen als auch von der jeweils betätigten Taste (4a - 6d) abhängt.


## Claims

1. Method for controlling an entertainment electronics apparatus (11) wherein the various operating modes of the apparatus (11) are set with a control unit (10); wherein operating instructions are reproduced in the form of on-screen displays on a screen (2) or on a display, the operating instructions being read out from a page memory (28) and presented on the screen (22) or the display by a reproduction control circuit (24), characterized in
-that at least part of the keys (4a - 6d) of the control unit (10) are switchable by a selector switch (3a) between a basic funtion and at least one additional function,
- that the operating instructions are combined in groups, the individual groups being each assigned to one of the basic or additional functions of the keys (4a - 6d),
- that, when the selector key (3a) is operated, the operating instructions assigned to the thereby selected basic or additional function are presented on the screen (2) or display, and
- that the control of the apparatus (11) carried out via the control unit (10) depends, on the one hand, on the basic or additional function selected and the group of operating instructions assigned thereto and, on the other hand, on the key (4a - 6d) operated in each case.

2. A method as claimed in Claim 1, characterized in that other entertainment electronics apparatuses (12, 13), too, are controlled via the keys (3a - 9b) of the control unit (10) and that for this purpose corresponding texts are read out from the page memory (28) and displayed on the screen.

3. A method as claimed in Claim 1, characterized in that the change-over from one group of key functions to another group of key functions takes place automatically after the lapse of a predetermined period of time.

4. A method as claimed in Claim 1, characterized in that a given group of key functions is selected by depressing first the group selection key (3a) and then another key (4a - 6b) or a combination of other keys.

5. A method as claimed in Claim 1, characterized in that two or more groups of key functions belonging together are combined in a packet and that the individual groups of a packet follow each other automatically or in response to a pressing of the selection key (3a).

6. A method as claimed in Claim 5, characterized in that, after the passage of a packet through a complete cycle, switching back to the basic functions of the keys (4a - 6d) takes place.

7. A method as claimed in Claim 1, characterized in that the switching back to the basic functions is brought about by operating a termination key (3b).

8. A method as claimed in Claim 1, characterized in that operation of a termination key (3b) initiates switching over to the first group of two or more groups of key functions combined to form a packet.

9. A method as claimed in Claim 1, characterized in that the basic functions are functions necessary for the most important adjustments of the apparatus, and that particularly important functions are assigned to keys (7b, 7c, 9a, 9b) without additional functions.

10. A method as claimed in Claim 1, characterized in that the respective key function applying, at least that of the keys with additional function (4a - 6d), is displayed on-screen in the form of a table showing the arrangement of the keys on the control unit (10).

11. A method as claimed in Claim 1, characterized in that various control functions can be initiated only after entry of one or more blocking codes which have not been displayed.

12. A method as claimed in Claim 1, wherein all or part of an adjustment is made by varying stored digital data, characterized in that this adjustment is made via the control unit (10) of the apparatus (11) and that operating instructions to assist in the adjustment are displayed on the screen (2).

13. An entertainment electronics apparatus which contains the following component parts:
- a screen (22) or a display panel on which, apart from the normal program content or the normal display, operating instructions for the user are reproduced;
- a reproduction control circuit (24) by which these operating instructions are output and the normal program content or the normally presented information in their place is simultaneously suppressed;
- a control unit (10) with which operations desired by the user are entered;
- a control character recognition circuit (23) by which control characters transmitted by the control unit (10) are evaluated and by which the reproduction control circuit (24) is controlled;
- a page memory (28) from which the operating instructions are called up in order to be displayed by means of a character generator (26) on the screen (2) or the display panel;
characterized in
- that the operating instructions are combined in groups in the page memory (28),
- that the control unit (10) is provided with a selection key (3a) by which at least part of its keys (4a - 6d) is switchable from a basic function to an additional function,
- that, by means of a page selection circuit (27), the group of operating instructions which corresponds to the function of the keys selected in each case is read out from the page memory (28) and presented, and
- that the control of the apparatus carried out via the control unit (10) depends both on the group of operating instructions displayed on the screen (2) or display panel in each case and on the key (4a - 6d) operated in each case.


**Revendications**

1. Procédé de commande d'un appareil d'électronique grand public dans lequel les différents modes de fonctionnement de l'appareil (11) sont établis au moyen d'un dispositif de commande (10) et dans lequel des indicateurs de commande sont reproduits en surimpression sur un écran (2) ou sur un afficheur, les indicateurs de commande étant lus par le dispositif de commande (10) dans une mémoire de pages d'indicateurs (28) et étant affichés sur l'écran (22) ou l'afficheur par un circuit de commande d'affichage (24), caractérisé en ce que:
- au moins une partie des touches (4a - 6d) du dispositif de commande (10) sont commutables entre une fonction de base et au moins une fonction additionnelle, par le moyen d'une touche de sélection (3a),
- les indicateurs de commande sont rassemblés en groupes, les groupes particuliers étant associés chacun à l'une des fonctions - de base ou additionnelles - des touches (4a - 6d),

- à l'actionnement de la touche de sélection (3a), les indicateurs de commande associés à la fonction ainsi sélectionnés - de base ou additionnelle - sont affichés sur l'écran (2) ou l'afficheur, et

- les commandes de l'appareil (11) exécutées par le dispositif de commande (10), dépendent, d'une part, de la fonction respective que est sélectionnée - de base ou additionnelle - et du groupe d'indicateurs de commande qui lui est associé et, d'autre part, de la touche respective qui est actionnée (4a - 6d).

2. Procédé conforme à la revendication 1, caractérisé en ce que d'autres appareils (12, 13) d'électronique grand public peuvent être commandés par les touches (3a-9b) du dispositif de commande et en ce que des textes correspondants sont lus à cette fin dans la mémoire de pages d'indicateurs (28) et sont affichés sur l'écran.

3. Procédé conforme à la revendication 1, caractérisé en ce que le passage d'un groupe de fonctions des touches à un autre groupe de fonctions des touches est automatiquement déclenché après l'écoulement d'une durée prédéterminée.

4. Procédé conforme à la revendication 1, caractérisé en ce qu'un groupe défini de fonctians de touches est sélectionné lorsque l'on presse d'abord la touche de sélection (3a), puis une autre touche (4a - 6b) ou une combinaison d'autres touches.

5. Procédé conforme à la revendication 1, caractérisé en ce que plusieurs groupes de fonctions de touches apparentées entre elles sont assemblés en un paquet et en ce que les groupes individuels d'un paquet se suivent automatiquement ou par pression sur la touche de sélection (3a).

6. Procédé conforme à la revendication 5, caractérisé en ce que, après passage de l'intégralité d'un paquet, le retour aux fonctions de base des touches (4a - 6d) est effectué.

7. Procédé conforme à la revendication 1, caractérisé en ce que le retour aux fonctions de base est provoqué par l'actionnement d'une touche de fin (3b).

8. Procédé conforme à la revendication 1, caractérisé en ce que l'actionnement d'une touche de fin (3b) provoque la commutation sur le premier groupe parmi plusieurs d'un paquet de groupes de fonctions de touches.

9. Procédé conforme à la revendication 1, caractérisé en ce que les fonctions de base sont des fonctions nécessaires aux ajustements les plus importants de l'appareil et en ce que les fonctions particulièrement importantes (7b, 7c, 9a, 9b) sont affectées à des touches sans fonctions additionnelles.

10. Procédé conforme à la revendication 1, caractérisé en ce que la fonction respective validée, au moins pour ce qui est des touches à fonction additionnelle (4a - 6d), est affichée sous la forme d'un tableau représentant l'agencement des touches sur le dispositif de commande (10).

11. Procédé conforme à la revendication 1, caractérisé en ce que diverses fonctions de commande peuvent être exécutées après la fourniture d'un ou plusieurs codes de contrôle qui ne sont pas affichés.

12. Procédé conforme à la revendication 1, dans lequel un ajustement total ou partiel est effectué par modification des valeurs numériques enregistrées, caractérisé en ce que cet ajustement est effectué par le dispositif de commande (10) de l'appareil (11) et en ce que de ce fait l'indicateur de commande servant à l'ajustement est affiché sur l'écran (2).

13. Appareil d'électronique grand public comprenant les parties composantes suivantes :

- un écran (22) ou un afficheur sur lequel, en plus du programme normal ou de l'affichage normal, les indicateurs de commande sont affichés pour l'utilisateur,

- un circuit de commande de reproduction (24) grâce auquel des indicateurs de commande sont engendrés et simultanément affichés en surimpression à la place du programme normal ou d'un affichage normal,

- un dispositif de commande (10), à l'aide duquel les ordres de commande de l'utilisateur sont introduits,

- un circuit de reconnaissance de caractères de commande (23) reconnaissant des caractères de commande, lesquels sont transmis au dispositif de commande (10) et qui commandent le dispositif de commande de reproduction (24),

- une mémoire de pages d'indicateurs (28) d'où les indicateurs de commande sont extraits et, au moyen d'un générateur de caractère (26), sont affichés sur l'écran (2) ou l'afficheur,

caractérisé en ce que:

- les indicateurs de commande sont réunis en groupes, dans la mémoire de pages d'indicateurs (28),

- le dispositif de commande (10) est pourvu d'une touche de sélection (3a) par laquelle au moins une partie de ses touches (4a - 6d) sont commutables d'une fonction de base dans une fonction additionnelle,

- le groupe d'indicateurs de commande correspondant à chaque fonction sélectionnée des touches, est lu par un circuit de sélection de page (27), dans la mémoire de pages d'indicateurs (28) et affiché, et

- les commandes de l'appareil exécutées par le dispositif de commande (10) dépendent du groupe respectif d'indicateurs de commande affiché sur l'écran (2) ou l'afficheur, en même temps que de chaque touche particulière actionnée (4a - 6d).

Fig.1

Fig. 2